# EUROPEAN PATENT APPLICATION

(11) **EP 1 349 007 A1**
(43) Date of publication of application: **01.10.2003**
(21) Application number: 03006934.8
(22) Date of filing: 26.03.2003
(51) Int. Cl.: G03F 7/075, G03F 7/00, G03F 7/004

(54) **Photosensitive Paste**

(30) Priority: 29.03.2002 JP 2002093593; 02.10.2002 JP 2002289622
(71) Applicant: Sumitomo Chemical Company, Limited, Chuo-ku Osaka 541-8550 (JP)
(72) Inventor: Yahagi, Isao, Tsuchiura-shi, Ibaraki (JP)
(74) Representative: Henkel, Feiler, Hänzel

(57) **Abstract**

An object of the present invention is to provide a photosensitive paste to produce a partition showing small variation in pattern size before and after a firing process. The object is achieved by a photosensitive paste comprising an alkali-soluble polyorganosiloxane resin composition, inorganic particle, and photosensitive compound.

## Description

### FIELD OF THE INVENTION

The present invention relates to a photosensitive paste.

### BACKGOURND OF THE INVENTION

In recent years, requiring for the technique of downsizing display and requiring for high resolution of display has been increasing, and in connection with these requirements, the improvement of pattern processing technique is desired. As pattern processing technique, for example, a photosensitive paste method is known, and this technique is used for forming partition of a back plate in a member of a plasma display.

As formation methods of a partition of a back plate in a plasma display, for example, a method is known in which a photosensitive paste comprising acrylic acid-styrene copolymers, glass powders, and photopolymerization initiators are applied on a substrate, then are exposed to light and developed to form a partition patterns, and subsequently are fired to obtain a partition (JP 2001-22064A). In this method, however, since glass powders were baked while acrylic acid-styrene copolymers used as binder are decomposed and removed, there was large variation in pattern size of the partition before and after a baking process.

### SUMMARY OF THE INVENTION

An object of the present invention is to provide a photosensitive paste to produce a partition showing small variation in pattern size before and after a firing process.

The present inventors performed an extensive studies in order to find out a photosensitive paste to produce a partition showing small variation in pattern size before and after a baking process, and as a result, and they found out that a partition showing a small variation in pattern size before and after a baking process can be obtained by using a photosensitive paste including an alkali-soluble polyorganosiloxane resin composition and inorganic particle, thus completed the present invention.

That is, the present invention relates to a photosensitive paste comprising an alkali-soluble polyorganosiloxane resin composition, inorganic particle, and photosensitive compound.

### DETAILED DESCRIPTION OF THE INVENTION

Hereinafter, the present invention will be described in detail.

The alkali-soluble polyorganosiloxane resin composition used for the present invention includes the composition comprising polyorganosiloxane having alkali-soluble groups, and a compound having polymerizable groups, the composition comprising polyorganosiloxane having polymerizable groups, and a compound having alkali-soluble groups, and the composition comprising polyorganosiloxane having both alkali-soluble groups and polymerizable groups.

The alkali-soluble group of the present invention means a group providing with the property of dissolving into alkali solution, and includes, for example, carboxyl group, hydroxyphenyl group and hexafluorocarbinol group.

The polymerizable group of the present invention means a group having a polymerization property, and includes, for example, epoxy group, oxetanyl group, acrylate group and methacrylate group.

The compound having polymerizable groups used for the present invention includes polyorganosiloxane having the above polymerizable group and a compound having the above polymerizable group with low molecular weight.

The preferable alkali-soluble polyorganosiloxane resin composition is a resin composition comprising following (A) and (B).
(A) A poly-organosiloxane resin containing at least one functional group selected from a group consisting of functional group represented by formula (2) and functional group represented by formula (3).
(B) A polyorganosiloxane resin having hydroxyl groups. 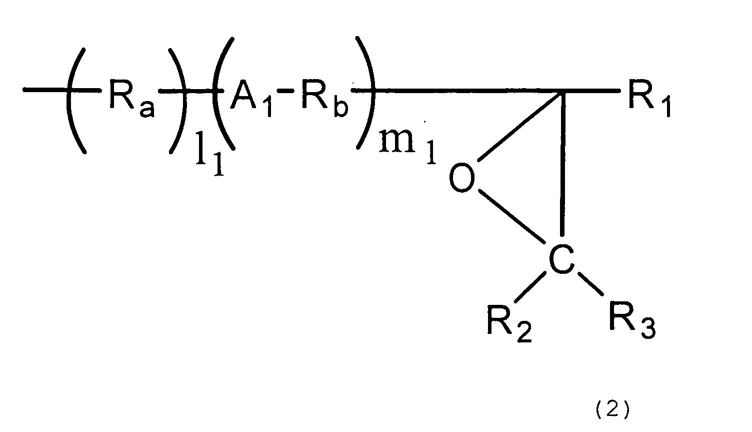 wherein, A₁ represents an oxygen atom or a sulfur atom, Rₐ and R_{b} independently represent a divalent organic group, R₁ through R₃ independently represent a hydrogen atom, or a monovalent organic group having 1 to 20 carbon atoms, and l₁ and m₁ represent an integer of no less than 0. 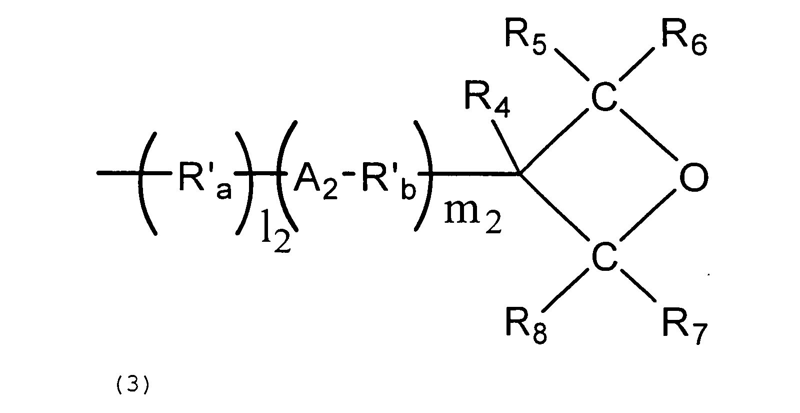 wherein, A₂ represents an oxygen atom or a sulfur atom, and R'ₐ and R'_{b} independently represent a divalent organic group, and R₄ through R₈ independently represent a hydrogen atom, or a monovalent organic group having 1 to 20 carbon atoms, and l₂ and m₂ represent an integer of no less than 0.

Here, Rₐ, R_{b}, R'ₐ, and R'_{b} represent divalent organic group, and may be any of linear structure, branched structure, and cyclic structure.

Divalent organic groups include, for example, alkylene groups, such as methylene group, ethylene, propylene group, butylene group, pentylene group, hexylene group, isopropylene group, and isobutylene group; cycloalkylene groups, such as cyclobutylene group, cyclopentylene group, and cyclohexylene group; arylene groups, such as phenylene group, naphtylene group, biphenylene group, and alkylation phenylene group.

R₁ through R₈ independently represent a hydrogen atom, or a monovalent organic group having 1 to 20 carbon atoms.

The monovalent organic group having 1 to 20 carbon atoms may be any of linear structure, branched structure, and cyclic structure. This includes, for example, linear aliphatic hydrocarbon groups having 1 to 20 carbon atoms, branched aliphatic hydrocarbon groups having 3 to 20 carbon atoms, cyclic aliphatic hydrocarbon groups having 3 to 20 carbon atoms, and aromatic hydrocarbon groups having 6 to 20 carbon atoms. The aromatic hydrocarbon groups having 6 to 20 carbon atoms may be substituted by alkyl groups, alkenyl groups, etc.

Among them, linear hydrocarbon groups having 1 to 6 carbon atoms, branched hydrocarbon groups having 3 to 6 carbon atoms, cyclic hydrocarbon groups having 3 to 6 carbon atoms, or aromatic hydrocarbon groups having 6 to 20 carbon atoms is preferable.

Linear aliphatic hydrocarbon groups having 1 to 20 carbon atoms include, for example, methyl group, ethyl group, propyl group, butyl, pentyl group, and hexyl group.

Branched aliphatic hydrocarbon groups having 3 to 20 carbon atoms include, for example, isopropyl group, isobutyl group, and tertiary butyl.

Cyclic aliphatic hydrocarbon groups having 3 to 20 carbon atoms include, for example, cyclopropyl group, cyclobutyl, cyclopentyl group, and cyclohexyl group.

Substituents of aromatic hydrocarbon groups having 6 to 20 carbon atoms include, for example, alkyl groups, such as methyl group, ethyl group, propyl group, and butyl, and alkenyl group such as ethynyl group.

Aromatic hydrocarbon groups having 6 to 20 carbon atoms include, for example, phenyl group, naphthyl group, anthryl group, tolyl group, xylyl group, trimethyl phenyl group, ethyl phenyl group, diethyl phenyl group, triethyl phenyl group, propylphenyl group, butylphenyl group, methyl naphthyl group, dimethyl naphthyl group, trimethyl naphthyl group, vinyl naphthyl group, methyl anthryl group, and ethyl anthryl group.

The functional groups represented by the formula (2) or (3) include, for example, oxiranyl group, glycidyl group, oxiranyl ethyl group, glycidyl oxyethyl group, glycidyl oxypropyl group, glycidyl oxyphenyl group, oxetanyl group, (3'-methyl-3'-oxetanyl)methyl group, 2-(3'-methyl-3'-oxetanyl)ethyl group, (3'-methyl-3'-oxetanyl)methyl oxyethyl group, (3'-methyl-3'-oxetanyl)methyl oxypropyl group, (3'-ethyl-3'-oxetanyl)methyl group, 2-(3'-ethyl-3'-oxetanyl)ethyl group, (3'-ethyl-3'-oxetanyl)methyl oxyethyl group, and (3'-ethyl-3'-oxetanyl)methyl oxypropyl group.

Polyorganosiloxane resins (A) containing at least one functional group selected from a group consisting of functional group represented by (2), and functional group represented by (3) include, for example, poly[glycidyloxypropylsilsesquioxane], poly[(3'-ethyl-3'-oxetanyl)methyloxypropylsilsesquioxane] etc.

The polyorganosiloxane resins (B) having hydroxyl groups include, for example, resins having phenolic hydroxyl group represented by a following formula (4). 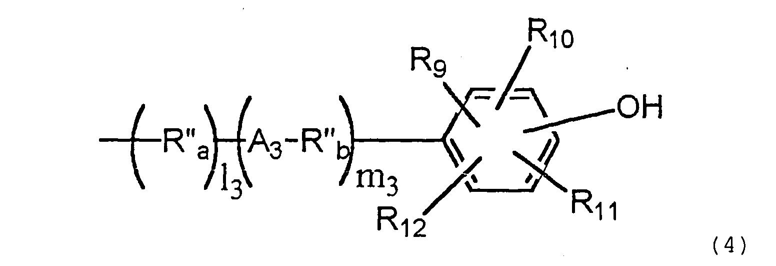 wherein, A₃ represents an oxygen atom or a sulfur atom, R''ₐ and R''_{b} independently represent a divalent organic group, R₉ through R₁₂ independently represent a hydrogen atom, or represent a hydroxyl group or a monovalent organic group having 1 to 20 carbon atoms, and l₃ and m₃ represent an integer of no less than 0.

In the formula (4), R₉ through R₁₂ independently represent a hydrogen atom, or represent a hydroxyl group or a monovalent organic group having 1 to 20 carbon atoms.

The monovalent organic group having 1 to 20 carbon atoms may be the same as the monovalent organic groups having 1 to 20 carbon atoms as mentioned above.

The functional groups represented by the formula (4) include, for example, hydroxyphenyl group, (hydroxyphenyl)methyl group, 2-(hydroxyphenyl)ethyl group, 1-(hydroxyphenyl)ethyl group, 3-(hydroxyphenyl)propyl group, 2-(hydroxyphenyl)propyl group, 1-(hydroxyphenyl)propyl group, etc.

The polyorganosiloxane resins having functional group represented by the formula (4) include, for example, poly silsesquioxane having dimethyl[2-(4'-hydroxyphenyl) ethyl]silyl group.

Polyorganosiloxane resins (B) having hydroxyl groups also include, for example, resins having functional group represented by a following formula (5). 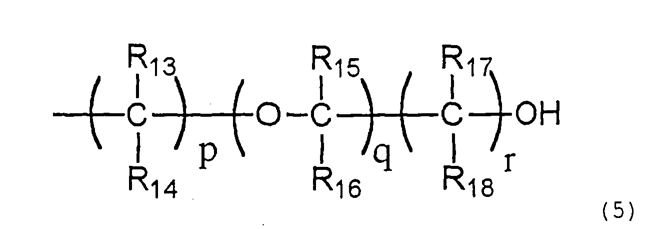 wherein, R₁₃ through R₁₈ independently represent a hydrogen atom, or represent a monovalent organic group having 1 to 20 carbon atoms, p and q represent an integer of no less than 0, and r represents an integer of no less than 1.

The monovalent organic group having 1 to 20 carbon atoms may be the same as mentioned above.

The p and q are integers of no less than 0, and are preferably no more than 20.

The r is an integer of no less than 1, and is preferably no more than 30.

The functional groups represented by the formula (5) include, for example, hydroxymethyl group, hydroxyethyl group, hydroxyethyl oxyethyl group, etc. The polyorganosiloxane resins having functional groups represented by the formula (5) include, for example, polysilsesquioxane having dimethyl(hydroxyethyloxyethy)lsilyl group.

As the resins (A) and (B), so long as they have the above-mentioned functional groups, the structure of the main chain of the siloxane resin is not especially limited, but the structure of the main chain may be of linear structure, ladder structure and cage structure.

As a mixing ratio of resins (A) and (B) in the alkali-soluble polyorganosiloxane resins composition, preferably the resin (A) may be from 5 to 85% by weight, and the resin (B) may be from 15 to 95% by weight, and more preferably the resin (A) may be from 10 to 70% by weight, and the resin (B) may be from 30 to 90% by weight. If a mixing ratio is out of the above-mentioned range, some problems in pattern formation may occur.

A weight average molecular weight of a polyorganosiloxane resin (A) containing at least one functional group selected from a group consisting of functional groups represented by the formula (2), and functional groups represented by the formula (3), is preferably from 350 to 30,000, and more preferably from 350 to 10,000. If the weight average molecular weight is less than 350, a curability of the area exposed by light may be insufficient, and if the weight average molecular weight is exceeding 30,000, solubility of a non-exposed area may be low, thus leading to problem occurrence in pattern formation property.

A polyorganosiloxane resin (A) containing at least one functional group selected from a group consisting of functional groups represented by the formula (2), and functional groups represented by the formula (3) can be produced by condensation of alkoxy silanes having functional groups represented by the formula (2) and/or the formula (3) in the presence of water using acid catalysts or alkali catalysts. In condensation reaction, co-polycondensation may be carried out under coexistence of tetraalkoxy silanes, trialkoxy organosilanes, dialkoxy organosilanes, or alkoxy triorganosilanes.

The alkoxy silanes having functional groups represented by the formula (2) or the formula (3) include glycidyloxypropyl triethoxysilane, oxetanyloxypropyl triethoxy silane, etc.

The acid catalysts include, for example, hydrochloric acid, acetic acid, etc. The alkali catalysts include, for example, ammonia, triethylamine, etc.

The tetraalkoxy silanes include, for example, tetramethoxy silane, tetra-ethoxy silane, etc.

The trialkoxy organosilanes include, for example, methyl trimethoxysilane, methyl triethoxysilane, ethyl trimethoxysilane, ethyl triethoxysilane, etc.

The dialkoxy diorganosilanes include, for example, dimethyl dimethoxysilane, dimethyl diethoxysilane, ethyl methyl dimethoxysilane, ethyl methyl diethoxysilane, etc.

The alkoxy triorganosilanes include, for example, methoxy trimethylsilane, ethoxy trimethylsilane, methoxy triethylsilane, ethoxy triethylsilane, ethyl dimethyl methoxysilane, etc.

The polyorganosiloxane resins having functional groups represented by the formula (2) may also be produced by condensing organoalkoxysilanes or organochlorosilanes having unsaturated bonds in the molecule according to the above-mentioned method and then by oxydizing with peroxides or ozones. In condensation reaction, co-polycondensation may be carried out under coexistance of the aforementioned tetraalkoxy silanes, trialkoxy organosilanes, dialkoxy diorgano silanes, alkoxy tri organosilanes, etc.

The organoalkoxysilanes or organochlorosilanes having unsaturated bonds in the molecule include dimethyl vinyl ethoxy silane, dimethyl vinyl chlorosilane, allyl dimethyl ethoxy silane, allyl dimethyl chlorosilane, etc.

The peroxides include m-chloro perbenzoic acid etc.

A weight average molecular weight of the polyorganosiloxane resins (B) having hydroxyl groups is preferably from 1,000 to 50,000, and more preferably from 1,000 to 30,000. If the weight average molecular weight is less than 1,000 or more than 50,000, the application property of the obtained paste may be insufficient, or pattern formation may be deteriorated.

The polyorganosiloxane resins (B) having hydroxyl groups can be produced by the method that an organoalkoxysilane is condensed according to the above-mentioned method, a silanol group at the terminal position is reacted with a chlorosilane compounds having protected hydroxyl groups to block the silanol group, and subsequently, the protecting group of the hydroxyl group is deblocked.

(B) can also be produced by the method that the organoalkoxysilanes having protected hydroxyl groups is condensed according to the above-mentioned method, and subsequently the protecting group of the hydroxyl groups is deblocked.

Here, organoalkoxysilanes include organo methoxy silanes and organo ethoxysilanes, such as tetraethoxysilane, tetramethoxysilane, methyl triethoxysilane, methyl trimethoxysilane, dimethyl diethoxysilane, dimethyl dimethoxysilane, trimethyl ethoxysilane, trimethyl methoxysilane, ethyl triethoxysilane, ethyl trimethoxysilane, diethyl diethoxysilane, diethyl dimethoxysilane, triethyl ethoxysilane, triethyl methoxysilane, phenyl triethoxysilane, phenyl trimethoxysilane, diphenyl diethoxysilane, diphenyl dimethoxysilane, triphenyl ethoxysilane, triphenyl methoxysilane, methylphenyl diethoxysilane, methylphenyl dimethoxysilane, dimethylphenyl ethoxysilane, dimethyl phenyl methoxysilane.

Chlorosilane compounds having protected hydroxyl groups may be prepared by the method that a compound having protected hydroxyl groups and unsaturated bonds such as vinyl groups and allyl groups in molecule, is hydrosilylated by dialkylchlorohydrosilane compounds in the presence of transition metal catalysts.

Chlorosilane compounds having protected hydroxyl groups can also be prepared by a condensation reaction between organometallic compounds having protected hydroxyl groups in molecule, and dialkyldichlorosilane compounds.

The protecting groups for hydroxyl group include, for example, alkyl groups, silyl groups, acyl groups, alkyl oxycarbonyl groups, etc.

These examples include methoxymethyl group, benzyl oxymethyl group, t-butoxy methyl group, 2-methoxy ethoxy methyl group, 2,2,2-trichloroethoxy methyl group, 2-(trimethylsilyl)ethoxymethyl group, tetrahydropyranyl group, 3-bromotetrahydro pyranyl group, tetrahydrothio pyranyl group, 4-methoxytetrahydro pyranyl group, tetrahydrofuranyl group, 1-ethoxyethyl group, 1-methyl-1-methoxyethyl group, 1-(isopropoxy)ethyl group, 2,2,2-trichloroethyl group, 2-(phenylselenyl)ethyl group, t-butyl group, benzyl group, 3-methyl-2-picolyl-N-oxide group, diphenyl methyl group, 5-dibenzosuberyl group, triphenyl methyl group, 9-anthryl group, trimethyl silyl group, triethyl silyl group, isopropyl dimethyl silyl group, t-butyl dimethyl silyl group, dimethyl(triphenylmethyl)silyl group, t-butyl diphenyl silyl group, methyl diisopropyl silyl group, methyl di-t-butyl silyl group, tribenzyl silyl group, triisopropyl silyl group, triphenyl silyl group, formyl group, acetyl group, 3-phenyl propionate group, 3-benzoyl propionate group, isobutylate group, 4-oxopentanoate group, pivaloate group, adamantoate group, benzoate group, methoxycarbonyl group, ethoxycarbonyl group, 2,2,2-trichloroethoxy carbonyl group, isobutyl oxycarbonyl group, etc.

The chlorosilane compounds having protected active hydrogen atoms in functional groups represented by the formula (4) include, for example, [2-(4'-trimethyl silyl oxyphenyl)ethyl]dimethyl chlorosilane, [2-(4'-t-butoxyphenyl)ethyl]dimethyl chlorosilane, etc.

In addition to the above-mentioned (A) and (B), an alkali-soluble polyorganosiloxane resin compositions may further include an alkali-soluble polyorganosiloxane resins (D) containing at least one functional group selected from a group consisting of the above-mentioned functional groups represented by the formula (2) and the above-mentioned functional groups represented by the formula (3), and at least one functional group selected from a group consisting of the above-mentioned functional groups represented by the formula (4) and functional groups represented by a formula (6).

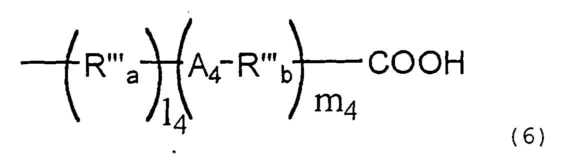

In the formula (6), A₄ represents an oxygen atom or a sulfur atom, R'''ₐ and R'''_{b} independently represents a divalent organic group, and l₄ and m₄ represent an integer of no less than 0. The examples for R'''a and R'''b may be the same groups as mentioned above.

A weight average molecular weight of the alkali-soluble polyorganosiloxane resin (D) is preferably from 1,000 to 50,000, and more preferably from 1,000 to 30,000.

The alkali-soluble polyorganosiloxane resin (D) may be produced by the method that a silanol group at the terminal group of polyorganosiloxane resins containing at least one functional group selected from a group consisting of functional groups represented by the formula (2) and functional groups represented by the formula (3), being prepared by the above-mentioned method, is reacted with chlorosilane compounds in which active hydrogen atom of at least one functional group selected from a group consisting of functional groups represented by the formula (4) and functional groups represented by the formula (6) is protected, to block the silanol group, and subsequently the protecting group is deblocked.

The alkali-soluble polyorganosiloxane resin (D) can also be produced by condensation reaction between alkoxy silanes having functional groups represented by the formula (2) or the formula (3), and alkoxy silanes having functional groups represented by the formula (4) or the formula (6) by the above-mentioned method.

The chlorosilane compounds in which active hydrogen atom of functional groups represented by the formula (4) is protected include, for example, [2-(4'-trimethylsilyl oxyphenyl)ethyl] dimethyl chlorosilane, [2-(4'-t-butoxy phenyl)ethyl] dimethyl chlorosilane, etc.

The chlorosilane compounds in which active hydrogen atom of functional groups represented by the formula (6) is protected include, for example, (trimethylsilyl oxycarbonyl propyl) dimethyl chlorosilane etc.

The alkali-soluble polyorganosiloxane resins (D) include, for example, polysilsesquioxanes having a (3'-ethyl-3'-oxetanyl)methyl oxypropyl group and carboxypropyl group.

The alkali-soluble polyoragnosiloxane resin composition of the present invention may comprise a polyorganosiloxane resin having hydroxyl groups (B) as above mentioned, and a compound (C) containing two or more of the functional groups represented by the above formula (2) and having a refractive index of from 1.35 to 1.80.

The compound containing two or more of the functional groups represented by the above formula (2) and having a refractive index of from 1.35 to 1.80 include, for example, ethyleneglycol diglycidyl ether, 1,4-butanediol diglycidyl ether,1,2,7,8-diepoxyoctane, neopentylglycol diglycidyl ether, 1,4-cyclohexanedimethanol diglycidyl ether, trimethylolpropane triglycidyl ether, glycerolpropoxylate triglycidyl ether and glycerol diglycidyl ether.

The inorganic particle used for the present invention is not restricted and its dielectric constant is preferably 9.5 or less, and more preferably 3.5 or less. Theinorganic particles used for the present invention include, for example, silica particles, such as colloidal silica, aerosil, and silica gel, and glass particles having silicon oxides as main component, or mixtures thereof.

A refractive index of the inorganic particle is preferably from 1.40 to 2.50, more preferably from 1.43 to 2.20, and still more preferably from 1.43 to 1.80. If the refractive index of the inorganic particle is less than 1.40 or more than 2.50, scattering of light becomes larger at the time of exposure, and the obtained pattern formation may not be satisfied.

An average particle diameter of the inorganic particle is determined depending on a shape of patterns to be formed, and it is preferably from 0.01 µm to 40µm, more preferably from 0.1 µm to 10 µm, and still more preferably from 0.1 µm to 5 µm.

If the average particle diameter is smaller than 0.01 µm, an amount to be charged may not be raised, and if exceeding 40 µm, scattering of light may be excessively large at the time of exposure, and there may be a tendency that pattern formation is not completed.

The inorganic particles having different average particle diameters may be used in the arbitrary mixing ratio. The shape of the inorganic particles is not restricted and is preferably spherical shape.

An addition amount of the inorganic particle is preferably from 20 to 95% by weight in a photosensitive paste, and is more preferably from 40 to 95% by weight.

If an addition amount of the inorganic particle is less than 20% by weight, shrinkage may become larger to separate from a substrate when fired, and if exceeding 95% by weight, scattering of exposure light in a pattern processing may become larger, leading to the failure of pattern formation.

In a photosensitive paste of the present invention, boric acid or derivative thereof may be further included.

A content of the boric acids or derivatives thereof used in the present invention is preferably from 0.1 to 30% by weight to the inorganic particle, more preferably from 0.5 to 20% by weight, and still more preferably from 1 to 10% by weight.

If it is less than 0.1% by weight, there may be tendency of poor adhesion to a substrate, and if exceeding 30% by weight, scattering of exposure light in a pattern processing may become larger, leading to the failure of pattern formation.

It is preferable that boric acid or derivatives thereof are supported by, or added to inorganic particles and then used after treated with silane coupling agents.

The supporting method may include a method in which inorganic particles are added into a solution including boric acid or derivatives thereof and then the solution is concentrated and dried, or a method in which inorganic particles are added into a solution including boric acid or derivatives thereof, followed by reprecipitation using a solvent that does not dissolve the boric acid or derivatives thereof.

The preferable examples of silane coupling agents include silane-coupling agents such as vinyl based, epoxy based, and oxetane based.

The examples of silane coupling agents include, for example, LS-70, LS-815, LS-2300, LS-4080, LS-2940, LS-3380, LS-4060, LS-1240, LS-1375, LS-1260 (manufactured by Shin-Etsu Chemical Co., Ltd.) ; TESOX (manufactured by TOAGOSEI CO., LTD.) etc.

Boron oxide etc. may be mentioned as the derivatives of said boric acid.

A photosensitive compound used for the present invention include compounds which form acid by electromagnetic irradiation or heat, and boric acid or derivatives thereof mentioned above may be used with the photosensitive compound.

The compounds which form acid with electromagnetic radiation or heat include, for example, photo-acid generating agents, optical cationic initiators, thermal cationic polymerization initiators, etc.

The photo-acid generating agents include, for example, [cyclohexyl-(2-cyclohexanonyl)-methyl]sulfonium, bis(p-tolylsulfonyl)diazomethane, bis(cyclohexylsulfonyl)diazomethane, tertiarybutylcarbonylmethyl-tetrahydrothiophenium, and etc. The photo-acid generating agents include, in addition to the above-mentioned compounds, compounds described in JP No.11-202495A.

The optical cationic polymerization initiators and thermal cationic polymerization initiators include, for example, iodonium salts, sulfonium salts, phosphate salts, antimonate salts, etc. RHODORSIL photo initiator 2074, Adekaoptomer SP-150, Adekaoptomer SP-152, Adekaoptomer SP-170, Adekaoptomer SP-172, and Adekaopton CP series etc. may be mentioned. In addition to the above-mentioned compounds, compounds described in JP No.09-118663A may also be used.

An amount of addition of these photo-acid generating agents, optical cationic polymerization initiators, and thermal cationic polymerization initiators is not especially limited, and the amount is preferably from 0.01% by weight to 20% by weight based on a whole amount of the photosensitive paste, more preferably from 0.05% by weight to 10% by weight. If the amount of addition is less than 0.01% by weight, curing may be hardly performed, and if exceeding 20% by weight, the effect of the amount of addition may not be sufficient.

A photosensitive compound used for the present invention also include compounds which form the acid represented as following formula (1) by electromagnetic radiation, and boric acid or derivatives thereof mentioned above, the compounds which form acid by electromagnetic or heat, or the mixture thereof may be used with this. 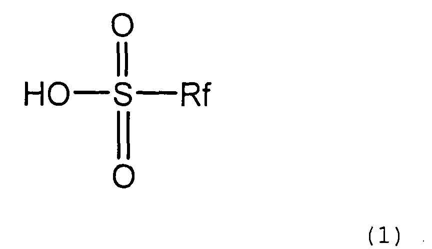 In the formula (1), Rf represents monovalent organic group having 1 to 20 carbon atoms which is substituted by fluorine.

The monovalent organic group having 1 to 20 carbon atoms which is substituted by fluorine include, for example, trifluoromethyl group, petafluoroethyl group, heptafluoropropyl group and heptafluorobutyl group.

The compound which form the acid represented as formula (1) by electromagnetic radiation include, for example, iodonium salts, sulfonium salts and ester compounds of the acid represented by formula (1).

The iodonium salts include, for example, DPI-105, DPI-106, DPI-109, BI-105, MPI-105, MPI-109, BBI-105 and BBI-109 manufactured by Midori Chemical Co.

The sulfonium salts include, for example, TPS-105, TPS-109, MDA-105, MDS-109, MDS-205, MDS-109, DTS-105, NDS-105, NDS-155, NDS-159 and NDS-165 manufactured by Midori Chemical Co.

The ester compounds include, for example, NAI-105, NAI-109, NDI-105, NDI-109, SI-105, SI-109, PI-105 and PI-109 manufactured by Midori Chemical Co.

A photosensitive paste of the present invention can be produced by mixing and homogeneously dispersing the alkali-soluble polyorganosiloxane resin compositions, the inorganic particles, the photosensitive compound, and boric acid or derivatives thereof if necessary, using a 3-roller mixer or a kneading machine, etc.

A photosensitive paste of the present invention usually contains dispersed media such as organic solvent. Viscosity of a photosensitive paste of the present invention can be adjusted in an arbitrary range by adding organic solvent. The organic solvent used for the present invention include, for example, organic solvents, such as 2-heptanon, propylene glycol monomethyl acetate, and gamma-butyrolactone.

Moreover, low molecule silicon compounds having carboxyl group may be added to a photosensitive paste of the present invention in order to make polyorganosiloxane resin compositions dissolved into alkali solution.

The low molecule silicon compounds include, for example, di(carboxy propyl)tetramethyl disiloxane etc.

Furthermore, low molecule silicon compounds having functional groups represented by the above-mentioned formula (2) or the formula (3) may be added to a photosensitive paste of the present invention, if necessary.

The low molecule silicon compounds include, for example, glycidyl oxypropyl trimethoxysilane, glycidyl oxypropyl triethoxysilane, oxetanyl oxypropyl trimethoxysilane, oxetanyl oxypropyl triethoxysilane, 1,3-bis(glycidyl oxypropyl)-1,1,3,3-tetramethyl-disiloxane, 1,3-dioxiranyl-1,1,3,3-tetramethyl-disiloxane, 1,3-bis(oxetanyl oxypropyl)-1,1,3,3-tetramethyl-disiloxane.

Additives, such as light absorbents, photosensitizers, plasticizers, dispersants, suspending agents, and leveling agents, may be added into a photosensitive paste of the present invention, if needed.

Although description will hereinafter be given about a method of carrying out a pattern formation processing using a photosensitive paste of the present invention to produce a device such as a display device, the present invention is not limited to the method.

First, a photosensitive paste is applied onto a whole surface or a partial surface of a substrate. The application method include, for example, a bar coater method, a roll coater method, a die coater method, and a screen-printing method to produce a coated film. The film thickness may be adjusted by selecting number of times of application, and viscosity of the paste, and is usually approximately 5 through 500 µm.

It is preferable that a substrate surface may be treated with a surface treatment agent when the photosensitive paste is applied onto a substrate in order to increase adhesion force between the substrate and the applied film.

The surface treatment agents include, for example, silane-coupling agents, such as glycidyl oxypropyl triethoxysilane, glycidyl oxypropyl trimethoxysilane, and oxetanyl oxypropyl triethoxysilane. When the silane coupling agents are used, they are preferably diluted to from 0.1 to 5% by weight of concentration using organic solvents, such as ethyleneglycol monomethyl ether, methyl alcohol, ethyl alcohol, propyl alcohol, and butyl alcohol.

The methods for surface treatment include, for example, a method in which a surface treatment agent is applied uniformly on a substrate using a spincoator etc. , and is subsequently dried for 5 through 60 minutes at 80 through 140°C.

After applied and dried, exposing process is carried out using exposure system. As exposure system, for example, a proximity exposure machine etc. may be mentioned.

When exposure needs to be carried out to a large area, after photosensitive paste is applied on a substrate, exposure is carried out while the substrate is being moved, and thus exposure for a large area may be carried out using an exposure machine having a small exposing area. Ultraviolet ray, electron ray, X-ray, visible light, and near infrared radiation, etc. may be used for exposing processing.

After exposure, development is carried out using a developer having different solubility to an exposed area from that to a non-exposed area. Developing process is usually carried out using a dip coating method, a spray method, a brush method, etc.

The developer include, for example, alkaline aqueous solutions of alkalis, such as tetra methyl ammonium hydroxide, monoethanolamine, diethanolamine, sodium hydroxide, sodium carbonate, potassium hydroxide, and potassium carbonate.

An alkali concentration in the aqueous solution is preferably from 0.05 to 5% by weight, and more preferably from 0.1 to 5% by weight. If the alkali concentration is less than 0.05% by weight, removing of soluble areas may become difficult, and if exceeding 5% by weight, patterns separate or non-soluble areas may be eroded.

In order to control the process, developing temperatures at the time of the developing process are preferably from about 15 to about 50°C.

After patterns are formed as mentioned above, backfiring may be carried out in firing furnace to form the partition. As for firing environments or firing temperatures, it is preferable to bake at from about 400°C to about 600°C in atmosphere of air, nitrogen, etc., although it changes depending on kind of photosensitive pastes or substrates used. A batch wise firing furnace and a continuous type firing furnace with belt method may be used as firing furnaces.

Especially when pattern processing is carried out on a glass substrate, the substrate is preferably maintained for from about 10 to about 60 minutes at from about 400 to about 600°C for firing.

Coating layers may be formed on a surface of a partition obtained.

The coating layer may be formed on the surface of the partition in a manner that a paste agent comprising of low melting point glass particles and binder resins, and a coating agent, such as ceramic coating agent, are applied, dried, and baked, or it may be simultaneously formed in formation of the partition on a surface of the partition, by applying the coating agent after aforementioned pattern formation, and subsequently by carrying out baking.

As low melting point glass particles, for example, tin oxide phosphoric acid based glass, bismuth oxide based glass, lead glass, etc. may be mentioned. Working temperature of the low melting point glass particle is usually approximately from 250°C to 480°C.

As binder resins, butyral resins, for example, polyvinyl alcohol, acrylic resins, poly α-methyl styrenes, etc. may be mentioned.

As ceramic coating agents, aqueous metal salt based coating agents, alkoxy metal salt based coating agents, etc. may be used. Specifically as aqueous metal salt based coating agent, MS-1700 (manufactured by NIPPON CERAMIC CO., LTD.) may be mentioned, and as alkoxy metal salt based coating agents, G-301 (manufactured by NIPPON CERAMIC CO., LTD.), G-401 (manufactured by NIPPON CERAMIC CO., LTD.), etc. may be mentioned.

Baking temperatures are usually approximately from 250°C to 600°C, when the paste agent containing the low melting point glass particle and the binder resin is used, and it is usually from room temperature to about 500°C when the ceramic coating agent is used.

Usually, a variation in pattern size before and after a baking process of a partition obtained is preferably no more than ±30%, and more preferably a variation in pattern size is no more than ±10%.

In this way, since a variation in pattern size is small, the partition may be suitably used as a partition for a back plate of a plasma display.

### EXAMPLES

The present invention will be described with the reference to examples, however the present invention is not limited to these examples.

### Manufacturing example 1

### Resin 1: Siloxane resin having phenolic hydroxyl group

Water 65g was dropped in to a mixture of tetra-ethoxy silane 187g, 2-(4'-t-butoxy phenyl)ethyl-dimethyl chlorosilane (mixture of α adduct and β adduct) 119g, and ethanol 100ml, and subsequently, reaction was carried out at 65°C for 1 hour. Subsequently, while nitrogen was being bubbled into the reaction mixture to evaporate the ethanol off, reaction was continued for 11 hours. Furthermore, methyl isobutyl ketone (MIBK) 200ml was added, and while the ethanol and the MIBK was subsequently evaporated off, reaction was carried out for 4.5 hours.

MIBK 300ml was added to the reacted liquid, and it was washed 3 times with water 300ml until water layer reached neutral state.

Water layer was separated, and subsequently organic layer was condensed to obtain a viscous siloxane resin solution.

Approximately 500ml of 2-heptanone was added to the siloxane resin solution, the solution obtained was partially condensed to obtain a 2-heptanone solution of siloxane resin. Solid content was measured and, as a result, 35.4% of concentration was obtained. Measurement by GPC gave a weight average molecular weight of 12,000.

Structural formula of the siloxane resin having phenolic hydroxyl groups :

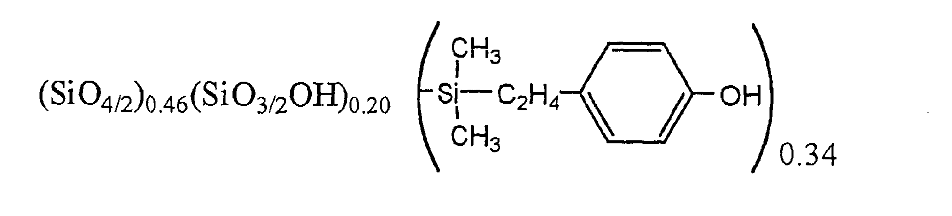

### Resin 2: Alkali-soluble siloxane resin

Ethanol 100ml, pyridine 9.4g, and trimethylchlorosilane 12.4g were introduced into a flask, and were agitated for 10 minutes. Tetraethoxysilane 40g, triethoxysilyl oxetane (manufactured by TOAGOSEI CO., LTD.) 40g, and 22.6g of aqueous ammonia of pH about 9 were added to the reaction mixture, and reaction was carried out for 24 hours. MIBK 200ml and water 100ml were added to terminate the reaction, the mixture was washed with 300ml of water 3 times, dried with anhydrous magnesium sulfate, and a solution of a siloxane resin was obtained.

The anhydrous magnesium sulfate was filtrated off, the flask was cooled in an ice bath, and, subsequently pyridine 8.7g and chloromethyl dimethyl chlorosilane 15g were added. After reaction was carried out in the ice bath for 3 hours, furthermore, reaction was continued at room temperature for two days.

After reacted, the mixture was washed with 300ml of water 3 times, and was dried with anhydrous magnesium sulfate.

Anhydrous magnesium sulfate was filtrated off, and subsequently pyridine 8g and trimethyl silyl oxy carbonyl propyl dimethyl chlorosilane (manufactured by TOAGOSEI CO., LTD.) 24g were added, and the mixture was reacted at room temperature for 24 hours. Reaction mixture was washed with 300ml of water 3 times after reacted, then it was dried and condensed with anhydrous magnesium sulfate, and a target material of viscous liquid was obtained. Yield was 19g. Measurement by GPC gave a weight average molecular weight of 2,000.

### Example 1

Into a 100 ml round bottom flask were introduced 10g of 35.4% of 2-heptanone solution of the resin 1 obtained in the manufacturing example 1, 1,3-di(3'-carboxypropyl)-1,1,3,3-tetramethyl-disiloxane 0.177g, oxetanylsilsesquioxane (manufactured by TOAGOSEI CO., LTD.) 1.77g, RHODORSIL photo initiator (manufactured by Rodale Co., PI-2074) 0.177g, andsensitizer (manufactured by ASAHI DENKA CO. , LTD., SP-100) 0.035g to prepare a uniform solution. Solvent was evaporated off with a rotary evaporator, and the mixture obtained was condensed to give a viscous solution of a photosensitive composition 7.2g.

Into an airtight container made of polypropylene, were introduced the above-mentioned alkali soluble siloxane resin solution 10 parts by weight, 1,3-bis(3'-glycidyl oxypropyl)-1,1,3,3-tetramethyl disiloxane (manufactured by Shin-Etsu Chemical Co., Ltd.; LS-7970) 8 parts by weight, 60 parts by weight of spherical silica, which surface is treated by epoxy, in which boron oxide 3% by weight is supported, and 2-heptanone approximately 5 parts by weight for viscosity controlling. The mixture was agitated using a degassing mixer HM-500 made by KEYENCE CORPORATION to prepare a uniform photosensitive paste.

The prepared photosensitive paste was applied 3 times on a glass substrate using an applicator having 200 µm gap.

The applied glass substrate was dried in 65°C oven for 20 minutes after a first and a second application, and after a third application, it was dried in 65°C oven for 1 hour to prepare a coated film.

Exposure was given using a mask having 90 µm line width and 300 µm pitch by a proximity exposure machine (manufactured by DAINIPPONN SCREEN MFG. CO., LTD., MAP-1300). Irradiated light exposure was 400 mJ/cm². After exposed, the substrate was baked for 20 minutes at 65°C, and, subsequently was developed in 2.38% of tetramethyl ammonium hydroxide aqueous solution. Thus, a pattern with a pattern upper width of 92 µm, a pattern lower width of 185 µm, and a height of approximately 200 µm was obtained.

The substrate was fired in a desktop electric furnace (Thermoline 48000) at 450°C for 60 minutes, and a pattern having a pattern upper width of 92 µm, a pattern lower width of 185 µm, and a height of approximately 200 µm was obtained without any separation.

### Example 2

Into a 300 ml round bottom flask were introduced 187.3g of 35.4% of 2-heptanone solution of the resin 1 obtained in the manufacturing example 1, 10.8g of the resin 2 obtained in the manufacturing example 1, oxetanylsilsesquioxane (manufactured by TOAGOSEI CO., LTD.) 33.2g, RHODORSIL photo initiator (manufactured by Rodale Co., PI-2074) 0.8g, and sensitizer (manufactured by ASAHI DENKA CO., LTD., SP-100) 0.2g to prepare a uniform solution. Solvent was evaporated off with a rotary evaporator, and the mixture obtained was condensed to give a viscous solution of a photosensitive composition 139g.

Into an airtight container made of polypropylene the above-mentioned alkali soluble siloxane resin solution 16.1 parts by weight, 1,3-bis(3'-glycidyl oxypropyl)-1,1,3,3-tetramethyl disiloxane (manufactured by Shin-Etsu Chemical Co., Ltd.; LS-7970) 8.1 parts by weight, spherical silica which surface is treated by epoxy (Admafine OS-C5) 72.6 parts by weight, 2-heptanone 3.2 parts by weight for viscosity controlling were introduced. The mixture was agitated using a degassing mixer HM-500 made by KEYENCE CORPORATION to prepare a uniform photosensitive paste.

Pattern was formed as in Example 1, using the prepared photosensitive paste. Irradiated light exposure was 1300 mJ/cm². After developed, obtained pattern width showed 92 µm in the upper part, 138 µm in the lower part, and 130 µm in height.

The substrate was fired on a high temperature hot plate (manufactured by Iuchi Co.,Ltd.; HTH-500) at 450°C for 10 minutes to obtain a pattern having a pattern upper width of 92 µm, a pattern lower width of 138 µm, and a height of approximately 130 µm without any separation.

### Example 3

26.2g of 38.3% of 2-heptanone solution of the resin 1 obtained in the manufacturing example 1, 0.33g of 1,3-bis(3'-carboxypropyl)-1,1,3,3-tetramethyldisiloxane, RHODORSIL photo initiator (manufactured by Rodale Co., PI-2074) 0.66g, and sensitizer (manufactured by ASAHI DENKA CO., LTD., SP-100) 0.07g and 2.61g of 2-heptanone are mixed to obtain a solution of alkali-soluble siloxane resin.

Into an airtight container made of polypropylene the above-mentioned alkali soluble siloxane resin solution 26.9 parts by weight, 1,3-bis(3'-glycidyl oxypropyl)-1,1,3,3-tetramethyl disiloxane (manufactured by Shin-Etsu Chemical Co., Ltd.; LS-7970) 13.3 parts by weight, spherical silica which surface is treated by epoxy (a mixture of Admafine OS-C5 and OS-C1 in the ratio of 7 to 3) 59.8 parts by weight and 0.03 parts by weight of a compound generating the acid represented by formula (7) were introduced. The mixture was agitated using a degassing mixer HM-500 made by KEYENCE CORPORATION to prepare a uniform photosensitive paste. The coated film was obtained as in Example 1, using the prepared photosensitive paste.

Exposure was given using a mask having 50 µm line width and 150 µm pitch by a proximity exposure machine (manufactured by DAINIPPONN SCREEN MFG. CO., LTD., MAP-1300). Irradiated light exposure was 800 mJ/cm². After exposed, the substrate was baked for 20 minutes at 65°C, and, subsequently was developed in 2% by weight of potassium hydroxide aqueous solution. Thus, a pattern with a pattern upper width of 60 µm, a pattern lower width of 100 µm, and a height of 150 µm was obtained.

The substrate was fired in a desktop electric furnace (Thermoline 48000) at 500°C for 2 hours, and a pattern having a pattern upper width of 60 µm, a pattern lower width of 100 µm, and a height of approximately 150 µm was obtained without any separation.

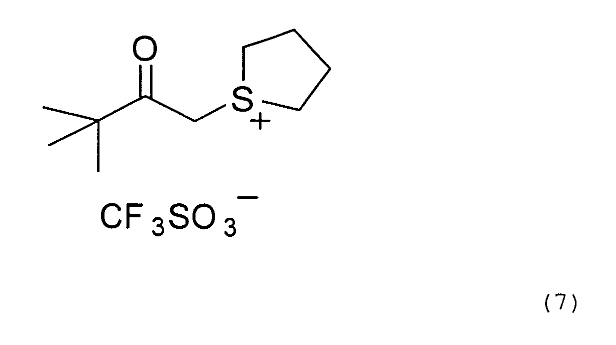

### Example 4

Into a 100 ml round bottom flask were introduced 53g of 38.0% of 2-heptanone solution of the resin 1 obtained in the manufacturing example 1, 0.66g of 1,3-bis(3'-carboxypropyl)-1,1,3,3-tetramethyldisiloxane, RHODORSIL photo initiator (manufactured by Rodale Co., PI-2074) 1.3g, and sensitizer (manufactured by ASAHI DENKA CO., LTD., SP-100) 0.13g to prepare a uniform solution. Solvent was evaporated off with a rotary evaporator, and the mixture obtained was condensed to give a viscous solution of a photosensitive composition 32g.

Into an airtight container made of polypropylene the above-mentioned alkali soluble siloxane resin solution 10.1 parts by weight, 1,3-bis(3'-glycidyl oxypropyl)-1,1,3,3-tetramethyl disiloxane (manufactured by Shin-Etsu Chemical Co., Ltd.; LS-7970) 8.7 parts by weight and 81.2 parts by weight of 2-heptanone solution of spherical silica which surface is treated by epoxy (Admafine OS-C5) and supported boron oxide 1.1% by weight (solid content: 70%) were introduced. The mixture was agitated using a degassing mixer HM-500 made by KEYENCE CORPORATION to prepare a uniform photosensitive paste. The prepared photosensitive paste was applied 1 time on a glass substrate using an applicator having 400 µm gap.

Exposure was given using a mask having 50 µm line width and 250 µm pitch by a proximity exposure machine (manufactured by DAINIPPONN SCREEN MFG. CO., LTD., MAP-1300). Irradiated light exposure was 600 mJ/cm². After exposed, the substrate was baked for 20 minutes at 65°C, and, subsequently was developed in 2% by weight of potassium hydroxide aqueous solution. Thus, a pattern with a pattern upper width of 60 µm, a pattern lower width of 68 µm, and a height of 173 µm was obtained.

According to the present invention, a photosensitive paste can be provided that may manufacture partitions having a small pattern size variation before and after baking processing.

## Claims

1. A photosensitive paste comprising an alkali-soluble polyorganosiloxane resin composition, inorganic particle, and photosensitive compound.

2. The photosensitive paste according to claim 1, wherein the inorganic particle has dielectric constant of 9.5 or less.

3. The photosensitive paste according to claim 1, wherein the inorganic particle is at least one selected from the group consisting of silica particles and glass particles.

4. The photosensitive paste according to claim 1 further containing boric acid or a derivative thereof.

5. The photosensitive paste according to claim 4, wherein a content of the boric acids or derivatives thereof is from 0.1 to 30% by weight to the inorganic particle.

6. The photosensitive paste according to claim 1, wherein the photosensitive compound is a compound which form acid by electromagnetic irradiation or heat.

7. The photosensitive paste according to claim 1, wherein the photosensitive compound is a compound which forms the acid represented as following formula (1) by electromagnetic irradiation, 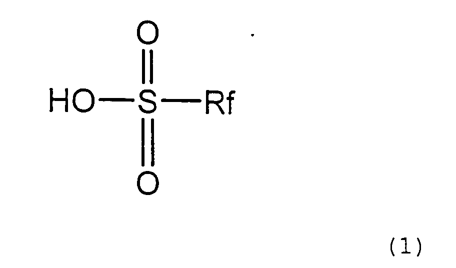 wherein Rf represents monovalent organic group having 1 to 20 carbon atoms which is substituted by fluorine.

8. The photosensitive paste according to claim 1, wherein the alkali-soluble polyorganosiloxane resin composition comprises a resin composition comprising following components (A) and (B);
(A) a poly-organosiloxane resin containing at least one functional group selected from a group consisting of functional group represented by formula (2) and functional group represented by formula (3) :
(B) a polyorganosiloxane resin having hydroxyl group, 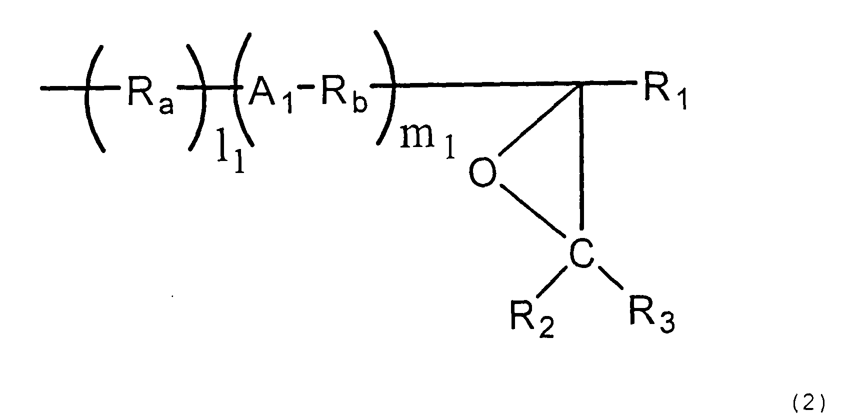 wherein, A₁ represents an oxygen atom or a sulfur atom, Rₐ and R_{b} independently represent a divalent organic group, R₁ through R₃ independently represent a hydrogen atom, or a monovalent organic group having 1 to 20 carbon atoms, and l₁ and m₁ represent an integer of notless than 0, 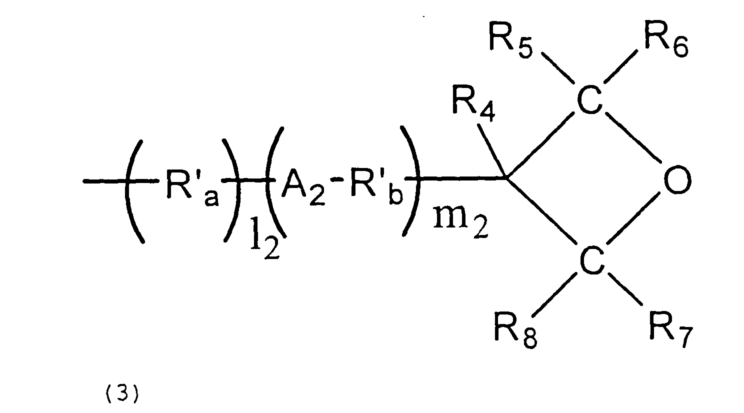 wherein, A₂ represents an oxygen atom or a sulfur atom, and R'ₐ and R'_{b} independently represent a divalent organic group, and R₄ through R₈ independently represent a hydrogen atom, or a monovalent organic group having 1 to 20 carbon atoms, and l₂ and m₂ represent an integer of no less than 0.

9. The photosensitive paste according to claim 8, wherein the polyorganosiloxane resin having hydroxyl group (B) is a resin having phenolic hydroxyl group represented by a following formula (4) ; 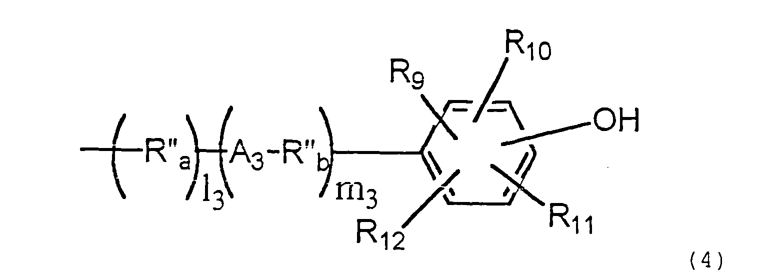 wherein, A₃ represents an oxygen atom or a sulfur atom, R''ₐ and R''_{b} independently represent a divalent organic group, R₉ through R₁₂ independently represent a hydrogen atom, or represent a hydroxyl group or a monovalent organic group having 1 to 20 carbon atoms, and l₃ and m₃ represent an integer of not less than 0.

10. The photosensitive paste according to claim 8, wherein the polyorganosiloxane resin having hydroxyl group (B) is a resin having functional group represented by a following formula (5) : 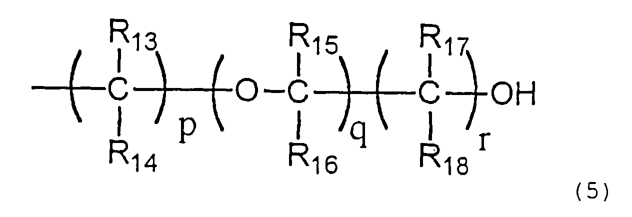 wherein, R₁₃ through R₁₈ independently represent a hydrogen atom, or represent a monovalent organic group having 1 to 20 carbon atoms, p and q represent an integer of no less than 0, and r represents an integer of notless than 1.

11. The photosensitive paste according to claim 1, wherein the alkali-soluble polyorganosiloxane resin composition comprises a composition comprising following components (B) and (C); (B) a polyorganosiloxane resin having hydroxyl groups:
(C) a compound containing two or more of the functional groups represented by the formula (2) and having a refractive index of from 1.35 to 1.80: 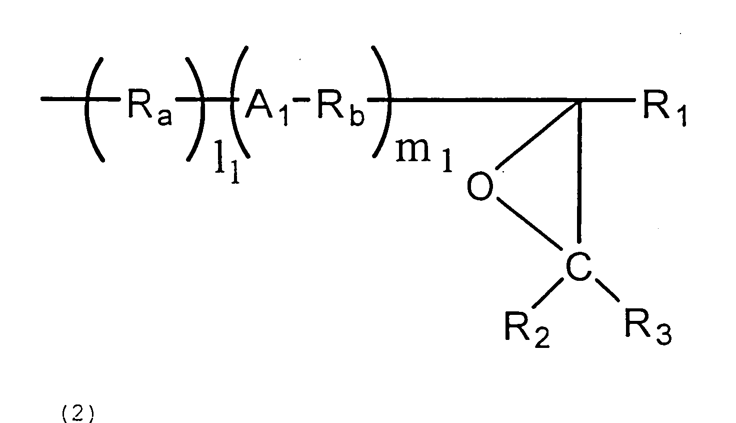
wherein, A₁ represents an oxygen atom or a sulfur atom, Rₐ and R_{b} independently represent a divalent organic group, R₁ through R₃ independently represent a hydrogen atom, or a monovalent organic group having 1 to 20 carbon atoms, and l₁ and m₁ represent an integer of not less than 0.

12. The photosensitive paste according to claim 1, wherein the inorganic particle has a refractive index of from 1.40 to 2.50.

13. The photosensitive paste according to claim 1, wherein the inorganic particle has an average particle diameter of from 0.01 µm to 40µm.

14. A method for producing a display device comprising;
applying onto a surface of a substrate a photosensitive paste comprising an alkali-soluble polyorganosiloxane resin composition, inorganic particle, and photosensitive compound,
drying to produce a coated film,
exposing the coated film,
developing the exposed film to form a partition pattern, and
firing the developed film to obtain a partition.

15. The method according to claim 14, wherein the surface of the substrate is treated with a surface treatment agent.

16. The method according to claim 14, further comprising forming a coating layer on the partition.
